# EUROPÄISCHE PATENTSCHRIFT

(11) **EP 0 258 334 B1**
(45) Veröffentlichungstag und Bekanntmachung des Hinweises auf die Patenterteilung: **05.05.1993**
(21) Anmeldenummer: 87901368.8
(22) Anmeldetag: 28.02.1987
(51) Int. Cl.: H01B 13/00

(54) **VERFAHREN ZUR HERSTELLUNG VON KABELBÄUMEN**
PROCESS FOR PRODUCING CABLE LOOMS
PROCEDE DE PRODUCTION DE CABLAGES PREASSEMBLES

(30) Priorität: 12.03.1986 DE 3608243
(43) Veröffentlichungstag der Anmeldung: 09.03.1988
(73) Patentinhaber: KOMAX AG, CH-6036 Dierikon-Luzern (CH)
(72) Erfinder: SCHLAICH, Gerd, D-7255 Rutesheim (DE)
(74) Vertreter: Münich, Wilhelm, Dr.
(86) Internationale Anmeldenummer: DE8700083
(87) Internationale Veröffentlichungsnummer: WO8705741

(56) Entgegenhaltungen:
- EP-A- 0 008 155
- EP-A- 0 182 591
- IBM Technical Disclosure Bulletin, vol. 27, No. 4B, September 1984, (New York, US), R.H. App et al.: "Computer-controlled cable harness manufacturing using a robot", pages 2467-2470

## Beschreibung

Die Erfindung bezieht sich auf ein Verfahren zur Herstellung eines Kabelbaums mit Hilfe eines Industrieroboters gemäß dem Oberbegriff des Patentanspruchs 1.

Ein Verfahren gemäß dem Oberbegriff des Patentanspruchs 1 ist beispielsweise aus der EP-A-0 008 155 bekannt.

Bei dem aus dieser Druckschrift bekannten Herstellungsverfahren wird so vorgegangen, daß der Industrieroboter innerhalb einer festinstallierten Peripherie Handhabungsaufgaben ausführt. Diese Vorgehensweise hat eine Reihe von Nachteilen:
- Die Raumkoordinaten der einzelnen Punkte in der Periphierie, die der Industrieroboter anfahren soll, müssen genau bekannt sein, um sie mit Hilfe der Off-Line erstellten Programme anfahren zu können.
- Bei der off-line-Programmierung müssen die Raumpunkte absolut angegeben und entsprechend angefahren werden. Beispielsweise aufgrund von Fertigungstoleranzen der Industrieroboterkinematik, von Rundungsfehlern bei der Berechnung der Sollkoordinaten der Einzelachsen usw. liegt die Ist-Position des Industrieroboters üblicherweise 0,1 mm bis 10 mm neben der Off-Line-programmierten Sollposition. Damit stellen die Off-Line-erstellten Programme nur die "Rohversion" eines lauffähigen Industrieroboter-Steuerprogramms dar, das durch nachträglich, manuell durchzuführende Korrekturen verbessert werden muß. Derartige Korrekturen sind zeitaufwendig und verhindern gegen wärtig beispielsweise den Einsatz von Industrierobotern für die Herstellung von Einzelstücken.

Der Erfindung liegt die Aufgabe zugrunde, ein Verfahren zur Herstellung eines Kabelbaums mit Hilfe eines Industrieroboters anzugeben, bei dem es nicht erforderlich ist, erstellte Ablauf-Programme an Ist-Positionen anzupassen.

Eine erfindungsgemäße Lösung dieser Aufgabe ist mit ihren Weiterbildungen in den Patentansprüchen angegeben.

Erfindungsgemäß ist erkannt worden, daß der spezielle Aufbau von Industrierobotern, d. h. insbesondere von 6-achsigen freiprogrammierbaren Handhabungseinrichtungen nur eine vergleichsweise geringe Positioniergenauigkeit, jedoch eine sehr große Wiederholgenauigkeit gestattet. Deshalb wird erfindungsgemäß das Einrichten der Verlegehilfen, das Verlegen der Kabel, das Ablängen sowie das Anschlagen der Kabel mit den selben Grundprogrammen ausgeführt, wobei ausgenutzt wird, daß die absolute Positioniergenauigkeit eines Industrieroboters zwar vergleichsweise gering, die Wiederholgenauigkeit beim Anfahren einprogrammierter Punkte jedoch groß ist.

Der grundliegende Erfindungsgedanke besteht nun darin, daß sich der Industrieroboter die Peripherie, die er zur Herstellung des zu fertigenden Kabelbaums benötigt, selbst aufbaut und in dieser Peripherie die durchzuführenden Handhabungsaufgaben erledigt. Da die einzelnen Herstellungsschritte, wie Bestücken der Steckergehäuse-Aufnahmeeinrichtungen mit Steckergehäusen, Verlegen der Kabel, Befestigen der Kabel an den Steckergehäusen, Abbinden des Kabelbaums, Entnahme des Kabelbaums usw. weitgehend unabhängig von der Geometrie des Kabelbaums sind, können diese Einzelschritte quasi als Unterprogramme durch fest eingegebene Ablaufprogramme der Steuereinheit durchgeführt werden.

Damit benötigt das erfindungsgemäße Verfahren nur noch die folgenden Schritte:
Zunächst werden die Geometriedaten (Länge der einzelnen Verzweigungen, Steckergröße an den einzelnen Endpunkten, Kabelzahl etc.)in die Steuereinheit eingegeben. Entsprechend diesen Geometriedaten positioniert der Industrieroboter Verlegehilfen wie Kabelhalter etc. und Steckergehäuse-Aufnahmeeinrichtungen. Diese "Off-Line" eingegebene Position wird vom Industrieroboter zwar nur mit der üblichen Genauigkeit (0,1 mm bis 10 mm) eingehalten, da die Wiederholgenauigkeit des Anfahrens der einzelnen Punkte jedoch sehr viel größer ist, fährt der Industrieroboter während der nachfolgenden Schritte problemlos erneut die vorher eingegebenen Punkte und damit beispielsweise die Steckergehäuse-Aufnahmeeinrichtungen an.

Damit ist es - obwohl die vorgegebenen Absolutkoordinaten der Industrieroboter-Steuerung nicht mit den tatsächlichen Absolutpositionen der Peripheriekomponenten übereinstimmen - jederzeit möglich, auch ohne nachträglichen Korrekturen off-line-programmierte Ablaufprogramme zu verwenden.

Weiterbildungen der Erfindung sind in den Unteransprüchen angegeben.

Gemäß Anspruch 2 ist es besonders vorteilhaft, wenn als Montageplatte eine Magnetspannplatte verwendet wird, deren Magnetfeld der Industrieroboter ein- und ausschaltet. Auf dieser Platte können alle benötigten Komponenten, wie Steckergehäuse- Aufnahmeeinrichtungen, Verlegehilfen etc. wahlfrei angeordnet werden.

Ferner ist es gemäß Anspruch 5 vorteilhaft, neben dem Montagebrett alle benötigten Peripheriekomponenten, wie Verlegewerkzeuge, Abbindewerkzeug, Anschlagwerkzeug, verschiedene Greifer, Steckergehäuse-Aufnahmeeinrichtungen, Verlegehilfen sowie Kabelrollen bereitzustellen. Die Bereitstellung kann dabei ebenfalls durch den Industrieroboter erfolgen, so daß sich keine Probleme hinsichtlich eventuellen Diskrepanzen zwischen Ist- und Sollkoordinaten ergeben.

Für die Kabelbaummontage mit Hilfe eines Industrieroboters ist es besonders geeignet, wenn gemäß Anspruch 3 die Kabel an den Steckern angeschlagen werden.

Durch das erfindungsgemäße Verfahren wird die Programmierung des Industrieroboters soweit vereinfacht, daß nur noch die Geometrie des Kabelbaums beispielsweise von einem CAD-System eingegeben werden muß. Aus diesen Kabelbaum-Geometriedaten wird das vollständige Abblaufprogramm für den Industrieroboter erzeugt, wobei die einzelnen Verfahrensschritte, wie Anschlagen der Kabel an den Steckern Abbinden der Kabel usw. als fest vorgegebene Unterprogramme aufgerufen werden, die zum Holen und Ablegen der einzelnen Peripheriekomponenten sowie zum Durchführen einzelner Schritte dienen.

Damit hat das erfindungsgemäße Verfahren den Vorteil, daß es sich ohne weiteres auch zum Herstellen von einzelnen Kabelbäumen eignet, da keinerlei "Nachprogrammierung" des Abblaufprogramms am Industrieroboter-Arbeitsplatz erforderlich ist.

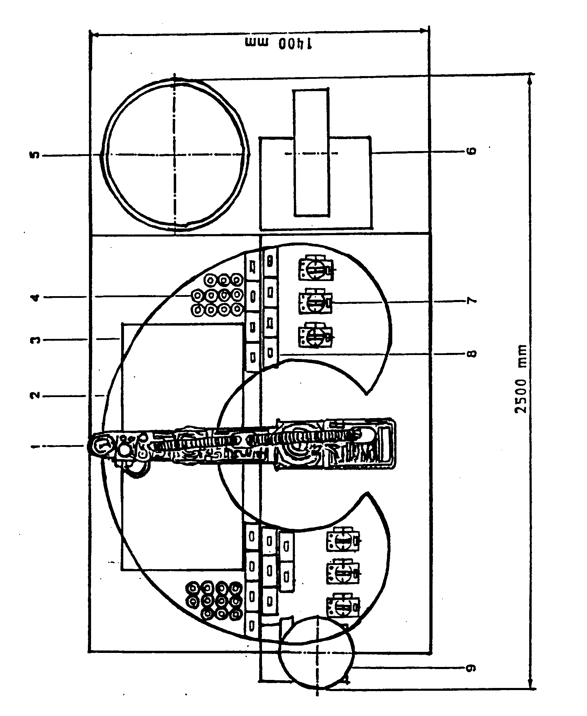

Die Erfindung wird nachstehend anhand eines Ausführungsbeispiels unter Bezugnahnme auf die Zeichnung näher beschrieben,
deren einzige Figur eine Aufsicht auf einen Industrieroboter-Arbeitsplatz zeigt.

In der Zeichnung ist schematisch ein Industrieroboter (1) dargestellt, dessen Arbeitsraum durch Linien (2) angedeutet ist. Innerhalb des Arbeitsraums (2) ist ein Verlegebrett (3), das vorzugsweise eine Magnetspann-Platte ist, angeordnet. Außerhalb des Verlegebretts (3), aber innerhalb des Arbeitsraums (2) des Industrieroboters sind die einzelnen benötigten Komponenten, Verlegehilfen (4), Kabel (5), Kabelbinder (6), Werkzeuge (7), wie Verlegewerkzeuge, Abbindewerkzeuge, Anschlagewerkzeuge, verschiedene Greifer etc. sowie Steckergehäuse-Aufnahmeeinrichtungen (8) bereitgestellt. Ferner ist ein beispielsweise sensorunterstützter Vibrations-Wendelförderer (9) vorgesehen, der Steckergehäuse in den Arbeitsraum (2) des Industrieroboters fördert.

Typische Abmessungen des Industrieroboter-Arbeitsraums sind ebenfalls in der Zeichnung enthalten.

Mit dieser Peripheriekonfiguration ist es möglich, wie folgt bei der Herstellung von Kabelbäumen vorzugehen:
Zunächst werden beispielsweise mittels eines CAD-Systems die Kabelbaum-Geometriedaten festgelegt und in die Steuereinheit des Industrieroboters eingegeben. Die Steuereinheit des Industrieroboters erzeugt aus diesen Geometriedaten ein Ablaufprogramm für die Herstellung des Kabelbaums, in dem fest vorgegebene Unterprogramme aufgerufen werden, die zum Holen, Bedienen und Ablegen der einzelnen Peripheriekomponenten dienen.

Zunächst holt sich der Industrieroboter (1) ein Greifwerkzeug (7) und setzt mit diesem Greifer wahlfrei auf dem als Magnetspannplatte ausgebildeten Verlegebrett (3) Steckergehäuse-Aufnahmeeinrichtungen (8) sowie Verlegehilfen (4) auf. Die Positionen der Komponenten (4) und (8) sind durch die zuvor eingegebenen Geometriedaten des Kabelbaums gegeben, die von CAD-System übernommen worden sind. Durch Aktivierung des Magnetfeldes der Magnetspannplatte durch den Industrieroboter werden die Komponenten (4) bzw. (8) sicher auf der Magnetspannplatte gehalten.

Das Aufnehmen des Greifers sowie das Ablegen des Greifers ist dabei als festes Unterprogramm in der Steuereinheit des Industrieroboters gespeichert. Nach dem Ablegen des Greifers nimmt der Industrieroboter einen anderen Greifer auf, mit dem er alle Steckergehäuse-Aufnahmeeinrichtungen (8) mit Steckergehäusen, in diesem Falle Schneidklemmverbindern bestückt, die er dem Vibrationswendelförderer (9) entnimmt. Anschließend wird auch dieser Greifer abgelegt und ein Verlegewerkzeug eingewechselt. Dieses Ablegen des Greifers und Einwechseln des Verlegewerkzeugs wird wiederum durch ein fest vorgegebenes Programm gesteuert. Mit diesem Verlegewerkzeug verlegt der Industrieroboter die einzelnen Kabel wahlfrei entsprechend den Off-Line eingegebenen Geometriedaten. Anschließend schlägt der Industrieroboter die Kabelstränge an den Schneidklemmverbindern an, bindet die Kabelstränge ab und entnimmt den Kabelbaum dem System, worauf er zur Montage des nächsten Kabelbaums zur Verfügung steht. Diese Vorgehensweise hat eine Reihe von Vorteilen:
Durch die Kombination fest vorgegebener Unterprogramme, mittels derer sich der Industrieroboter Komponenten von um das Verlegebrett angeordneten Stellen, wie Magazinen etc. holt, mit Off-Line eingegebenen Geometriedaten des Kabelbaums , wobei sich der Industrieroboter die Verlegehilfen mit diesen Off-Line-Daten selbst bereitstellt, wird erreicht, daß der Industrieroboter die Verlegehilfen direkt und ohne Nachprogrammierung anfahren kann. Damit müssen die Unterprogramme, mit denen sich der Industrieroboter beispielsweise spezielle Greifer holt, nur einmal eingegeben werden, während die Bewegungsprogramme für die eigentliche Montage an einem CAD-System-off-line erstellt werden können. Hierdurch wird eine große Zeitersparnis bei der Vorbereitung der Herstellung erreicht. Damit ermöglicht das erfindungsgemäße Verfahren auch die Fertigung von einzelnen Kabelbäumen.

In jedem Falle hat das erfindungsgemäße Verfahren den Vorteil, daß das Bewegungsprogramm des Industrieroboters Off-Line erstellt werden kann, ohne daß nachträglich Bewegungspunkte geändert werden müssen.

## Patentansprüche

1. Verfahren zur Herstellung von Kabelbäumen mit Hilfe eines Industrieroboters (1), den eine elektronische Steuereinheit steuert, in die die Geometrie des Kabelbaums eingebbar ist, und in der einzelne, von der speziellen Geometrie des Kabelbaums unabhängige Programmschritte fest gespeichert sind, bei dem der Industrieroboter (1) entsprechend den eingegebenen Geometriedaten Verlegehilfen (4) auf einem Montagebrett (3) positioniert, und nach dem Einwechseln eines Verlegewerkzeugs das oder die Kabel (5) verlegt, und den Kabelbaum entnimmt,
**gekennzeichnet** durch die Kombination folgender Schritte, - vor dem Verlegen der Kabel (5) positioniert der Industrieroboter (1) unter Verwendung derselben Programmschritte Steckergehäusen-Aufnahmeeinrichtungen (8) auf dem Montagebrett (3) und bestückt die Steckergehäuse-Aufnahmeeinrichtungen (8) mit Steckergehäusen, - nach dem Verlegen eines oder mehrerer Kabel (5) wechselt der Industrieroboter (1) ein Montagewerkzeug ein und befestigt unter Verwendung derselben Programmschritte das oder die Kabel (5) an den Steckergehäusen.

2. Verfahren nach Anspruch 1,
dadurch **gekennzeichnet**, daß das Montagebrett (3) eine Magnetspannplatte ist.

3. Verfahren nach Anspruch 1 oder 2,
dadurch **gekennzeichnet**, daß die Steckergehäuse Schneidklemmverbinder sind.

4. Verfahren nach einem der Ansprüche 1 bis 3,
dadurch **gekennzeichnet**, daß der Industrieroboter die Kabel (5) abbindet.

5. Verfahren nach einem der Ansprüche 1 bis 4,
dadurch **gekennzeichnet**, daß Verlegehilfen (4), Steckergehäuse-Aufnahmeeinrichtungen (8), Werkzeuge (7), Kabel (5) sowie Steckergehäuse neben dem Montagebrett (3) positioniert sind.

6. Verfahren nach Anspruch 5,
dadurch **gekennzeichnet**, daß der Industrieroboter (1) zur Einrichtung seines Arbeitsplatzes Verlegehilfen (4), Steckergehäuse-Aufnahmeeinrichtungen (8), Werkzeuge (7) etc. neben dem Montagebrett (3) positioniert.

7. Verfahren nach einem der Ansprüche 1 bis 5,
dadurch **gekennzeichnet**, daß die Geometriedaten von einem CAD-System in die Steuereinheit eingegeben werden.

## Claims

1. Method of producing cable harnesses by means of an industrial robot (1) under control of an electronic controller into which the geometry of the cable harness may be entered and wherein individual program steps, which are independent of the specific cable harness geometry, are invariable stored, in which method the industrial robot (1) positions laying accessories (4) on a mounting panel (3) in accordance with the entered geometrical data, and lays the cable(s) (5) after a laying tool has been substituted, and removes the cable harness.
**characterized** by the combination of the following steps:
- prior to laying the cables (5) the industrial robot uses the same program steps to position plug base receptacles (8) on the mounting panel (3) and equips said plug base receptacles (8) with plug bases,
- after the laying of one or several cables (5) the industrial robot (1) substitutes the tool by a mounting tool and uses the same program steps for attachment of the cable(s) (5) to the plug bases.

2. Method according to Claim 1,
**characterized** in that said mounting panel (3) is a magnetic clamping plate.

3. Method according to Claim 1 or 2,
**characterized** in that said plug bases are cutting clamp connectors.

4. Method according to any of Claims 1 to 3,
**characterized** in that said industrial robot (5) assembles the cables (5).

5. Method according to any of Claims 1 to 4,
**characterized** in that laying accessories (4), plug base receptacles (8), tools (7), cables (5) as well as plug bases are positioned beside the mounting panel (3).

6. Method according to Claim 5,
**characterized** in that said industrial robot (1) positions laying accessories (4), plug base receptacles (8), tools (7), etc. beside the mounting panel (3) for installing and equipping its work station.

7. Method according to any of Claims 1 to 5,
**characterized** in that the geometrical data is entered into the controller from a CAD system.

## Revendications

1. Procédé de production d'un harnais de câbles en utilisant un robot industriel (1) commandé par un organe de commande électronique dans lequel on peut introduire la géométrie de l'harnais et qui contient des étapes de programme individuels, qui sont indépendants de la géométrie particulière de l'harnais, y mémorisés comme constantes, dans lequel le robot industriel (1) positionne des aides de montage (4) sur une plaque de montage (3) en correspondance avec les données géométriques introduites, et, après la prise d'un outil de pose en échange, pose le ou les câbles (5) et enlève le harnais de câbles,
**caractérisé** par la combinaison des étapes suivantes:
- avant la pose des câbles (5) le robot industriel (1) positionne, en utilisant les mêmes étapes de programme, des porteurs pour les logements de prise (8) sur ladite plaque de montage (3) et équipe lesdits porteurs (8) par des logements de prise,
- après la pose d'un ou plusieurs câbles (5) le robot industriel (1) prend un outil de montage en échange et fixe le ou les câbles (5) aux logements de prise, en utilisant les mêmes étapes de programme.

2. Procédé selon la revendication 1,
**caractérisé** en ce que la plaque de montage (3) est une plaque de fixation magnétique.

3. Procédé selon la revendication 1 ou 2,
**caractérisé** en ce que les logements de prise sont des éléments de serrage coupant.

4. Procédé selon une quelconque des revendications 1 à 3,
**caractérisé** en ce que ledit robot industriel (5) assemble les câbles (5).

5. Procédé selon une quelconque des revendications 1 à 4,
**caractérisé** en ce que des aides de pose (4), des porteurs pour les logements de prise (8), l'outillage (7), des câbles (5) ainsi que les logements de prise sont positionné à côté de la plaque de montage (3).

6. Procédé selon la revendication 5,
**caractérisé** en ce que ledit robot industriel (1) positionne des aides de pose (4), des porteurs pour les logements de prise (8), l'outillage (7), etc. à côté de la plaque de montage (3) pour l'installation de son poste de travail.

7. Procédé selon une quelconque des revendications 1 à 5,
**caractérisé** en ce que les données géométriques sont introduite d'un système de conception assisté par ordinateur dans l'organe de commande.
